# EUROPÄISCHE PATENTSCHRIFT

(11) **EP 3 385 111 B1**
(45) Veröffentlichungstag und Bekanntmachung des Hinweises auf die Patenterteilung: **21.10.2020**
(21) Anmeldenummer: 18164681.1
(22) Anmeldetag: 28.03.2018
(51) Int. Cl.: B60N 2/00, B60N 2/90, B60R 16/037

(54) **VERFAHREN ZUM BETRIEB EINER MASSAGEEINRICHTUNG EINES SITZES**
METHOD FOR OPERATING A MASSAGE DEVICE OF A SEAT
PROCÉDÉ DE FONCTIONNEMENT D'UN DISPOSITIF DE MASSAGE D'UN SIÈGE

(30) Priorität: 06.04.2017 DE 102017205934
(43) Veröffentlichungstag der Anmeldung: 10.10.2018
(73) Patentinhaber: Brose Fahrzeugteile SE & Co. Kommanditgesellschaft, Bamberg, 96052 Bamberg (DE)
(72) Erfinder: MÜLLER, Alexander, 96120 Bischberg (DE)
(74) Vertreter: FDST Patentanwälte

(56) Entgegenhaltungen:
- EP-A1- 2 138 345
- WO-A1-2016/047459
- DE-A1-102010 049 152
- DE-T2- 60 100 412
- KR-A- 20150 114 033

## Beschreibung

Die Erfindung betrifft ein Verfahren zum Betrieb einer Massageeinrichtung eines Sitzes sowie eine Massageeinrichtung eines Sitzes als auch die Verwendung eines Bestandteiles einer Massageeinrichtung eines Sitzes. Der Sitz ist bevorzugt ein Bestandteil eines Kraftfahrzeugs. Die Erfindung betrifft ferner einen Fahrzeugsitz eines Kraftfahrzeugs.

Kraftfahrzeuge umfassen eine Anzahl an Nebenaggregaten, die nicht direkt dem Vortrieb des Kraftfahrzeugs dienen. Meist wird mittels dieser Nebenaggregate ein Komfort des Benutzers des Kraftfahrzeugs erhöht. Ein derartiges Nebenaggregat ist eine Massageeinrichtung, die ein Bestandteil eines Fahrzeugsitzes ist. Hierbei wird bei Aktivierung ein bestimmter Bereich des Fahrzeugsitzes periodisch verstellt, wie eine Rückenlehne oder ein Teil einer Rückenlehne. Aufgrund dessen wird eine Durchblutung eines Benutzers des Fahrzeugsitzes angeregt, weswegen eine Benutzung des Kraftfahrzeugs angenehmer ist. Auch können mittels des Kraftfahrzeugs auf diese Weise Fahrten mit einer vergleichsweise großen zeitlichen Dauer ausgeführt werden, ohne dass der Benutzer ermüdet.

Kraftfahrzeugsitze weisen zudem üblicherweise eine Sitzbelegungserkennung auf. In Abhängigkeit der Sitzbelegungserkennung erfolgt beispielsweise eine Überwachung des korrekten Anlegens eines Gurtes und gegebenenfalls die Ausgabe eines Warntons. Zudem werden, um Kosten zu sparen, üblicherweise in einem Crash-Fall lediglich dann die Airbags aktiviert, sofern der Sitz belegt ist. Zur Erkennung, ob der Sitz belegt ist, wird üblicherweise ein Gewichtssensor verwendet, oder eine Deformation des Sitzes aufgrund der Belegung durch eine Person wird erfasst. In einer Alternative hierzu wird eine kapazitive Sensorelektrode herangezogen, mittels derer im Bereich des Sitzes ein elektromagnetisches Feld erstellt und überwacht wird. Eine Änderung einer Dielektrizitätskonstante wird hierbei aufgrund einer Veränderung der Kapazität erfasst. Die Änderung der Dielektrizitätskonstanten rührt hierbei von der Anwesenheit einer Person im Bereich des Sitzes her. Sofern somit eine Änderung der Kapazität erfasst wird, ist auch eine Belegung des Sitzes erkannt.

Aus DE 601 00 412 T2 ist eine Sitzfläche mit massierender Wirkung bekannt. Es ist ein Druckgefühl unter der Oberfläche angeordnet, mittels dessen überprüft wird, ob der Sitz besetzt ist.

Der Erfindung liegt die Aufgabe zugrunde, ein besonders geeignetes Verfahren zum Betrieb einer Massageeinrichtung sowie eine besonders geeignete Massageeinrichtung eines Sitzes als auch einen besonders geeigneten Fahrzeugsitz eines Kraftfahrzeugs und eine besonders geeignete Verwendung eines Bestandteiles einer Massageeinrichtung eines Sitzes anzugeben, wobei insbesondere Herstellungskosten verringert und vorzugsweise eine Lebensdauer erhöht und geeigneterweise ein akustischer Eindruck verbessert ist.

Hinsichtlich des Verfahrens wird diese Aufgabe durch die Merkmale des Anspruchs 1, hinsichtlich der Massageeinrichtung durch die Merkmale des Anspruchs 6, hinsichtlich des Fahrzeugsitzes durch die Merkmale des Anspruchs 8 und hinsichtlich der Verwendung durch die Merkmale des Anspruchs 9 erfindungsgemäß gelöst. Vorteilhafte Weiterbildungen und Ausgestaltungen sind Gegenstand der jeweiligen Unteransprüche.

Das Verfahren dient dem Betrieb einer Massageeinrichtung. Die Massageeinrichtung ist ein Bestandteil eines Sitzes, und bestimmungsgemäß wird mittels der Massageeinrichtung eine Massagefunktion ausgeführt. Hierbei wird beispielsweise ein Bestandteil des Sitzes, wie die Sitzfläche oder eine Lehne, bewegt, insbesondere periodisch. Der Sitz und somit die Massageeinrichtung ist bevorzugt ein Bestandteil eines Kraftfahrzeugs, und der Sitz ist beispielsweise ein Fahrersitz oder ein Beifahrersitz.

Die Masseeinrichtung weist einen (ersten) Massageantrieb und eine (erste) elektrische Leitung auf, wobei die elektrische Leitung dem Betrieb des Massageantriebs dient. Hierbei wird mittels der elektrischen Leitung beispielsweise in einem bestimmten Betriebsmodus ein elektrischer Strom bzw. eine elektrische Spannung bereitgestellt. Mit anderen Worten handelt es sich bei der elektrischen Leitung um eine Stromleitung. In einer weiteren Alternative handelt es sich bei der elektrischen Leitung um eine Datenleitung, wobei über die Datenleitung insbesondere Betriebsparameter zu dem Massageantrieb geleitet werden, sodass anhand der elektrischen Leitung ein Betrieb des Massageantriebs erfolgt. Beispielsweise erfolgt mittels der elektrischen Leitung eine Einstellung einer Bestromung des Massageantriebs, wobei über die elektrische Leitung beispielsweise die zur Bestromung korrespondierenden Parameter übertragen werden. Zusammenfassend ist die elektrische Leitung mit dem Massageantrieb elektrisch kontaktiert.

Der Massageantrieb weist eine mittels eines Elektromotors angetriebene Unwucht auf, und die elektrische Leitung dient zweckmäßigerweise dem Betrieb des Elektromotors. Mittels des Elektromotors ist eine Unwucht angetrieben. Aufgrund dieser Unwucht wird geeigneterweise der Massageantrieb in eine Bewegung versetzt, wobei diese Bewegung periodisch ist. Hierbei ist der Massageantrieb im Montagezustand zweckmäßigerweise mit einem weiteren Bestandteil des Sitzes gekoppelt, beispielsweise einer Lehne oder Sitzfläche, so dass mittels der Unwucht der jeweilige Bestandteil bewegt, insbesondere ausgebeult, wird.

Das Verfahren sieht vor, dass in einem ersten Arbeitsschritt mittels eines Bestandteils der Massageeinrichtung selbst eine Änderung einer Kapazität aufgrund einer Änderung einer Belegung zumindest eines Abschnitts des Sitzes erfasst wird. Unter Kapazität wird nachfolgend insbesondere die elektrische Kapazität, beispielsweise eines elektrischen Feldes und/oder eines elektrischen Kondensators, verstanden. Hierbei wird geeigneterweise die elektrische Kapazität erfasst, und mittels des Bestandteils der Massageeinrichtung, mittels dessen die Erfassung erfolgt, ist zweckmäßigerweise zumindest teilweise ein Kondensator gebildet. Hierbei wirkt der Bestandteil bevorzugt als kapazitive Sensorelektrode. Beispielsweise wird mittels des Bestandteils ein elektromagnetische Feld erfasst oder zumindest teilweise das elektromagnetisches Feld erstellt. Hierbei ist der Bestandteil derart vorgesehen und eingerichtet, dass lediglich oder zumindest dann, wenn die Belegung des Abschnitts des Sitzes erfolgt, die Änderung der Kapazität erfasst wird. Mit anderen Worten wird, wenn der Abschnitt des Sitzes, beispielsweise die Sitzfläche oder ein Teil einer Sitzfläche, ein Teil einer Lehne oder die vollständige Lehne, belegt wird, die Änderung der Kapazität erfasst. Zusammenfassend ist der Abschnitt beispielsweise ein Bereich einer Sitzfläche bzw. einer Lehne oder die Sitzfläche oder die vollständige Lehne. Alternativ hierzu ist der Abschnitt mittels der Lehne und der Sitzfläche des Sitzes gebildet.

Zusammenfassend wird erfasst, wenn aufgrund der Belegung die Dielektrizitätskonstante geändert wird. Mit anderen Worten wird, falls eine Person sich auf den Sitz setzt, die Dielektrizitätskonstante verändert, so dass diese verschieden von der Dielektrizitätskonstante von Luft ist. Dies wird mittels des Bestandteils der Massageeinrichtung erfasst, welcher als ein Bestandteil eines Kondensators fungiert. Die Änderung der Kapazität wird beispielsweise erfasst, indem ein Absolutwert erfasst und mit einer theoretischen Vorgabe verglichen wird. In einer Alternative hierzu wird beispielsweise zu bestimmten Zeitpunkten, insbesondere im Abstand von 1 Minute, 10 Sekunden, 1 Sekunde oder 0,5 Sekunden, jeweils die Kapazität erfasst. Geeigneterweise werden die zeitlich aufeinanderfolgenden erfassten Kapazitäten miteinander verglichen und hieraus die Änderung der Kapazität abgeleitet. Zusammenfassend wird insbesondere anhand der Änderung der Kapazität auf eine Änderung der Belegung zumindest eines Abschnitts des Sitzes geschlossen.

In einem weiteren Arbeitsschritt wird anhand der Änderung der Kapazität eine Bestromung des Elektromotors angepasst. Aufgrund der Anpassung der Bestromung wird hierbei ein mittels des Elektromotors auf die Unwucht übertragenes Drehmoment angepasst und/oder eine Drehgeschwindigkeit der Unwucht angepasst. Somit wird insbesondere die Bestromung des Elektromotors in Abhängigkeit der Belegung des Abschnittes des Sitzes angepasst, wobei die Belegung anhand des Bestandteils der Massageeinrichtung selbst erfasst wird, welcher bevorzugt als kapazitive Sensorelektrode verwendet wird. Zum Beispiel wird die Belegung des Abschnittes des Sitzes erkannt, welcher mittels des Elektromotors, dessen Bestromung angepasst wird, zur Ausübung der Massagefunktion bewegt wird bzw. bewegt werden kann.

Aufgrund der Anpassung der Bestromung in Abhängigkeit der erfassten Belegung wird die Massagefunktion auf den Benutzer angepasst, was einen Komfort für diesen erhöht. Zudem ist zur Erkennung der Belegung kein weiteres zusätzliches Bauteil erforderlich, weswegen Herstellungskosten gesenkt sind. Ferner ist es nicht erforderlich, weiteren Bauraum zur Verfügung zu stellen, weswegen eine vergleichsweise kompakte Massageeinrichtung bereitgestellt ist. Auch wird auf diese Weise eine Lebensdauer des Elektromotors erhöht. Geeigneterweise erfolgt kein Betrieb des Elektromotors mit Maximalleistung, sofern beispielsweise keine Belegung erkannt ist, was einen akustischen Eindruck verbessert. Dies ist aufgrund der fehlenden Belegung auch nicht erforderlich.

Beispielsweise wird die Kapazität im Anschluss an eine Benutzereingabe erfasst. Zum Beispiel wird mittels der Benutzereingabe die Massageeinrichtung aktiviert. In Abhängigkeit der Benutzereingabe wird beispielsweise die Bestromung des Massageantriebs, insbesondere des Elektromotors, aufgenommen und somit die Unwucht in eine Bewegung versetzt. Im Anschluss hieran oder zeitgleich oder zeitlich vorhergehend, zumindest jedoch nach Erfassung der Benutzereingabe, wird die Kapazität erfasst und in Abhängigkeit der Kapazität die Bestromung des Elektromotors angepasst. Hierbei wird beispielsweise die Bestromung von einem festen Vorgabewert, der im Anschluss an die Benutzereingabe vorgegeben ist, in Abhängigkeit der Kapazität erhöht oder erniedrigt. Da die Kapazität im Anschluss an die Benutzereingabe erfasst wird, die insbesondere zu einer Aktivierung der Massageeinrichtung korrespondiert, wird die Änderung der Belegung lediglich dann erfasst, wenn auch der Massageantrieb aktiviert werden soll. Somit ist eine elektromagnetische Verträglichkeit (emV) erhöht, da, insbesondere sofern mittels des Bestandteils der Massageeinrichtung ein elektromagnetisches Feld erstellt wird, ein Aussenden von elektromagnetischen Feldern verringert ist. Nach Erfassen der Benutzereingabe wird die Erfassung der Kapazität zweckmäßigerweise wiederholt, insbesondere zyklisch, beispielsweise in einem Abstand von 5 Minuten, 1 Minute, 10 Sekunden, 1 Sekunde oder 0,5 Sekunden. Somit ist stets die Information vorhanden, ob der Abschnitt belegt ist.

Zusammenfassend korrespondiert die Benutzereingabe zur einer Aktivierung der Massageeinrichtung. Sofern der Sitz ein Bestandteil des Kraftfahrzeugs ist, ist in einer weiteren Alternative die Benutzereingabe beispielsweise ein Entriegeln des Kraftfahrzeugs oder ein Starten eines Verbrennungsmotors oder ein Versetzen eines Elektromotors des Kraftfahrzeugs in eine derartigen Betriebszustand, dass bei einer Betätigung eines sogenannten Gaspedals ein Vortrieb des Kraftfahrzeugs erfolgt. Folglich wird dann, wenn das Kraftfahrzeug in einen Zustand versetzt wird, in dem dieses benutzt werden kann, bzw. in dem dieses vorwärts bewegt werden kann, die Belegung des Sitzes erkannt. Geeigneterweise wird eine erfasste Belegung des Sitzes an einen Bordcomputer eines Kraftfahrzeugs weitergeleitet, beispielsweise über ein Bussystem oder zumindest wird diese Information über ein Bussystem zur Verfügung gestellt. Sofern die Massageeinrichtung kein Bestandteil eines Kraftfahrzeugs ist, korrespondiert die Benutzereingabe beispielsweise zu einem Versetzen der Massageeinrichtung aus einem ausgeschalteten Zustand in einen Stand-By-Modus.

Insbesondere wird eine Bestromung vergrößert, falls die erfasst Kapazität zu einer Belegung des Abschnitts des Sitzes korrespondiert. Beispielsweise wird die Bestromung auf einen Maximalwert gesetzt, welcher insbesondere aufgrund von baulichen Vorgaben des Massageantriebs bestimmt ist. Alternativ oder in Kombination hierzu wird die Bestromung aufgenommen, so dass die Bestromung von einem Wert von Null (0) auf einen bestimmten Wert gesetzt wird. Dieser ist beispielsweise das Maximum oder ein weiterer Wert, welcher zwischen dem Maximum und dem vorhergehenden Zustand keiner Bestromung liegt. Zweckmäßigerweise ist der Massageantrieb dem Abschnitt des Sitzes zugeordnet, dessen Belegung erfasst wird. Geeigneterweise wird somit die Bestromung aufgenommen, falls die Belegung erkannt ist.

Alternativ oder in Kombination hierzu wird bevorzugt die Bestromung des Elektromotors verringert, und beispielsweise vollständig reduziert und somit unterbrochen, sofern keine Belegung des Abschnitts erfasst ist. In einer Alternative hierzu wird der Elektromotor in einem bestimmten Bereich betrieben und die Bestromung hierauf angepasst, in dem der akustische Eindruck des Elektromotors verbessert ist. Insbesondere ist in diesem Betriebsbereich ein Aussenden von akustischen Signalen verringert. Infolgedessen ist der akustische Eindruck für den Benutzer verbessert. Zudem wird lediglich dann der Elektromotor im Wesentlichen mit einer vergleichsweise hohen Leistungsabgabe betrieben, sofern dies aufgrund der Belegung erforderlich ist. Sofern keine Belegung erkannt ist, wird der Elektromotor mit einer verringerten Leistung betrieben, was einen Energieverbrauch senkt und die Lebensdauer des Massageantriebs erhöht. Hierbei ist der Eindruck auf den Benutzer nicht verschlechtert, da dieser aufgrund der mangelnden Belegung die Massagewirkung des Massageantriebs nicht wahrnimmt.

Beispielsweise wird die Kapazität zwischen dem Bestandteil und Masse ermittelt. Sofern der Massageantrieb ein Bestandteil des Kraftfahrzeugs ist, wird hierbei beispielsweise die Kapazität zwischen dem Bestandteil und der Karosserie oder einem elektrisch leitend mit der Karosserie verbundenen Element ermittelt, insbesondere einer Trägerstruktur/ Haltestruktur des Sitzes. Mit anderen Worten bildet der Bestandteil eine Elektrode und die Masse die zweite Elektrode des Kondensators, dessen Kapazität bzw. dessen Änderung der Kapazität aufgrund der Änderungen der Belegung des Abschnitts des Sitzes erfasst wird. Beispielsweise wird mittels Anlegen eines elektrischen Potentials an den Bestandteil eine elektrische Spannung zwischen dem Bestandteil und der Masse erstellt. Zum Beispiel wird eine Wechselspannung an den Bestandteil angelegt. Anhand einer Änderung/einem Auftreten eines elektrischen Stroms wird zweckmäßigerweise die Kapazität erfasst. Alternativ wird die Kapazität zwischen dem Bestandteil und einem weiteren Bestandteil des Massageantriebs erfasst.

Geeigneterweise weist die Massageeinrichtung einen zweiten Massagenantrieb auf, der insbesondere ebenfalls eine mittels eines Elektromotors angetriebene Unwucht aufweist und vorzugsweise baugleich zu dem Massageantrieb ist. Der zweite Massageantrieb wird mittels einer zweiten elektrischen Leitung betreiben, die elektrisch mit dem zweiten Massageantrieb kontaktiert ist und vorzugsweise baugleich zur elektrischen Leitung ist. Mit anderen Worten dient die zweite elektrische Leitung dem Betrieb des zweiten Massageantriebs. In einer Alternative wird die Kapazität zwischen dem Bestandteil und dem zweiten Massageantriebs ermittelt, zum Beispiel einem zweiten Bestandteil des zweiten Massageantriebs. Die Kapazität wird somit zwischen dem Bestandteil und dem zweiten Bestandteil des zweiten Massageantriebs und/oder der zweiten elektrischen Leitung ermittelt. Mit anderen Worten wird die eine Elektrode mit dem Bestandteil des Massageantriebs und die zweite Elektrode mit dem zweiten Bestandteil des zweiten Massageantriebs oder der zweiten elektrischen Leitung gebildet. Somit erfolgt die Bestimmung der Kapazität mittels zweier Elemente der Massageeinrichtung, die geeigneterweise in einem definierten geometrischen Verhältnis, insbesondere in einem festen Abstand oder nahezu festen Abstand, zueinander angeordnet sind. Infolgedessen kann die Montage des Massageantriebs an dem Sitz vergleichsweise frei erfolgen, und verschiedene Typen von Sitzen können herangezogen werden, ohne dass die bestimmte Montageposition einen vergleichsweise großen Einfluss auf die erfasste Kapazität hat. Somit wird die Kapazität im Wesentlichen lediglich aufgrund der Belegung des Abschnitts des Sitzes bestimmt.

In einer zweiten Alternative wird als Bestandteil ein Gehäuse des Massageantriebs herangezogen. Das Gehäuse ist zweckmäßigerweise aus einem Metall, beispielsweise einem Blech gefertigt. Zumindest jedoch ist das Gehäuse aus einem elektrisch leitfähigen Material erstellt. Insbesondere wird das Gehäuse des Elektromotors als der Bestandteil herangezogen und verwendet. Geeigneterweise wird hierbei die Kapazität erfasst, wenn der Massageantrieb nicht bestromt ist. Hierfür wird geeigneterweise ein elektrisches Potential an das Gehäuse angelegt. Sofern eine Bestromung des Antriebs erfolgt, wird geeigneterweise das Gehäuse elektrisch mit Masse verbunden, so dass ein Aussenden von ungewollten elektromagnetischen Wellen aufgrund des Elektromotors im Wesentlichen unterbunden ist. Somit wird das Gehäuse bei nicht angetriebener Unwucht als die kapazitive Sensorelektrode verwendet. Infolgedessen wird ein bereits vorhandenes und elektrisch kontaktiertes Bauteil als kapazitive Sensorelektrode herangezogen, was Herstellungskosten weiter reduziert.

In einer weiteren Alternative wird als Bestandteil die elektrische Leitung herangezogen, wobei die elektrische Leitung beispielsweise eine Stromleitung oder eine Datenleitung ist und insbesondere einadrig oder mehradrig ausgestaltet ist. Die elektrische Leitung kann vergleichsweise frei innerhalb weiterer Bestandteile des Sitzes, wie eines Sitzkissens oder einer Rückenlehne verlegt werden. Folglich kann der mittels der elektrischen Leitung überwachte Bereich vergleichsweise frei bestimmt werden, sodass der Abschnitt im Wesentlichen frei gewählt werden kann. Auf diese Weise ist eine Flexibilität erhöht, und es ist kein weiterer Bestandteil erforderlich, da die Leitung bereits dem Betrieb des Massageantriebs dient und somit zwei Funktionen erfüllt, was Herstellungskosten reduziert.

Die Massageeinrichtung ist ein Bestandteil eines Sitzes und beispielsweise ein Bestandteil eines Kraftfahrzeugs. Insbesondere ist hierbei die Massageeinrichtung ein Bestandteil eines Fahrersitzes oder eines Beifahrersitzes. Die Massageeinrichtung weist einen Massageantrieb auf, der eine mittels eines Elektromotors angetriebene Unwucht umfasst. Ferner weist die Massageeinrichtung eine elektrische Leitung zum Betrieb des Massageantriebs auf. Hierfür ist die elektrische Leitung geeigneterweise elektrisch mit dem Massageantrieb, zweckmäßigerweise mit dem Elektromotor, elektrisch kontaktiert. Der Massagenantrieb und/oder die elektrische Leitung sind einem (ersten) Abschnitt zugeordnet. Mit anderen Worten sind der Massagenantrieb bzw. die elektrische Leitung einem bestimmten Raumbereich zugeordnet oder zumindest zuordenbar, so dass die räumliche Position des Massagenantriebs bzw. die elektrische Leitung bestimmt ist. Im Montagezustand ist der Abschnitt geeigneterweise ein Bestandteil des Sitzes, und der Massagenantrieb bzw. die elektrische Leitung sind diesem Bestandteil des Sitzes zuordenbar. Beispielsweise ist der Abschnitt ein Bereich einer Sitzfläche oder einer Lehne des Sitzes. Alternativ hierzu ist der Abschnitt die vollständige Sitzfläche oder die vollständige Lehne oder die Kombination aus Sitzfläche und Lehne.

Die Massageeinrichtung ist gemäß einem Verfahren betrieben, bei dem mittels eines Bestandteils der Massageeinrichtung eine Änderung einer Kapazität aufgrund einer Änderung eine Belegung des Abschnitts des Sitzes erfasst wird. Anhand der Änderung der Kapazität wird die Bestromung des Elektromotors angepasst. Somit sind der Massageantrieb bzw. die elektrische Leitung dem Abschnitt derart zugeordnet, dass die Änderung der Kapazität aufgrund einer Änderung der Belegung des Abschnitts des Sitzes erfasst wird. Zweckmäßigerweise wird bei Betrieb des Elektromotors ein Abschnitt oder zumindest ein Bereich des Abschnitts mittels des Elektromotors bzw. der Unwucht bewegt.

Ferner sieht das Verfahren vor, dass als Bestandteil ein Gehäuse des Massageantriebs oder die elektrische Leitung herangezogen wird, oder dass die Kapazität zwischen dem Bestandteil und einem zweiten Massageantrieb und/oder einer zweiten elektrischen Leitung ermittelt wird.

Die Massageeinrichtung umfasst zweckmäßigerweise ein Steuergerät / eine Steuereinrichtung, das bzw. die geeignet, vorzugsweise vorgesehen und eingerichtet ist, das Verfahren durchzuführen. Die Steuereinrichtung ist beispielsweise eine zentrale Steuereinrichtung (Steuergerät) der Massageeinrichtung oder Bestandteil des Massageantriebs und geeigneterweise an dem Elektromotor befestigt. Zum Beispiel dient hierbei die Steuereinheit zusätzlich der Einstellung der Bestromung des Elektromotors. Vorzugsweise umfasst die Massageeinrichtung zusätzlich ein zentrales Steuergerät, mittels dessen beispielsweise eine Kommunikation mit weiteren Bestandteilen, beispielsweise einer Eingabevorrichtung und/oder einem Bussystem erfolgt, insbesondere sofern die Massageeinrichtung ein Bestandteil des Kraftfahrzeugs ist.

Die Massageeinrichtung umfasst beispielsweise einen dritten Massageantrieb und/oder eine dritte elektrische Leitung, die einem zweiten Abschnitt zugeordnet sind. Geeigneterweise dient die dritte elektrische Leitung dem Betrieb des dritten Massageantriebs. Der zweite Abschnitt ist nicht deckungsgleich mit dem (ersten) Abschnitt und beispielsweise zu diesem beabstandet oder an diesen angrenzend. Geeigneterweise wird die Massageeinrichtung derart betrieben, dass mittels des dritten Massageantriebs und/oder der dritten elektrischen Leitung eine Änderung einer zweiten Kapazität aufgrund einer Änderung einer Belegung des zweiten Abschnitts erfasst wird. Anhand der Änderung der zweiten Kapazität wird insbesondere die Bestromung des dritten Massageantriebs angepasst. Der dritte Massageantrieb umfasst geeigneterweise ebenfalls einen Elektromotor und eine Unwucht und ist vorzugsweise baugleich zu dem (ersten) Massageantrieb. Die dritte elektrische Leitung ist vorzugsweise baugleich zur (ersten) elektrischen Leitung. Beispielsweise wird der dritte Massageantrieb bzw. die dritte elektrische Leitung als zweiter Massageantrieb bzw. als zweite elektrische Leitung herangezogen, und die Kapazität wird zwischen dem dritten Massageantrieb bzw. der dritten elektrischen Leitung und dem Bestandteil des Massageantriebs ermittelt. Vorzugsweise umfasst der dritte Massageantrieb ebenfalls eine Steuereinrichtung, insbesondere sofern der Massageantrieb eine umfasst. Infolgedessen wird im Wesentlichen dezentral erfasst, ob die Belegung des jeweils zugeordneten Abschnitts erfolgt, wobei geeigneterweise eine generelle Aktivierung mittels einer zentralen Steuereinheit vorgegeben ist.

Die Massageeinrichtung besteht zweckmäßigerweise lediglich aus dem Massageantrieb sowie der elektrischen Leitung bzw. den Massageantrieben und den elektrischen Leitungen. Beispielsweise besteht die Massageeinrichtung aus den Massageantrieben, den elektrischen Leitungen sowie einem etwaigen Steuergerät. Zumindest jedoch weist die Massageeinrichtung insbesondere keine separate kapazitive Sensorelektrode oder sonstige Sensoren auf, mittels derer eine Belegung des Sitzes erfasst werden kann, also die insbesondere vorgesehen und eingerichtet sind, lediglich die Belegung des Abschnitts des Sitzes zu erkennen.

Der Fahrzeugsitz ist ein Bestandteil eines Kraftfahrzeugs und weist eine Massageeinrichtung auf. Der Fahrzeugsitz ist zweckmäßigerweise ein Fahrersitz, also der Sitz, der von einem Führer des Kraftfahrzeugs eingenommen wird. Der Fahrzeugsitz umfasst insbesondere eine Sitzfläche und geeigneterweise eine Lehne. Die Sitzfläche und/oder die Lehne weisen zweckmäßigerweise ein Formteil aus Kaltschaum auf, welcher mittels eines Überzugs versehen ist, beispielsweise einem Stoff oder Leder. Zudem umfasst der Fahrzeugsitz eine Massageeinrichtung mit einem Massageantrieb, der eine mittels eines Elektromotors angetriebene Unwucht aufweist, und mit einer elektrischen Leitung zum Betrieb des Massageantriebs, wobei der Massageantrieb und/oder die elektrische Leitung einem Abschnitt des Sitzes zugeordnet sind. Der Massageantrieb ist zweckmäßigerweise in einer Aussparung innerhalb des Formteils aus Kaltschaum angeordnet, und bei Betrieb der Unwucht wird geeigneterweise der Überzug, also insbesondere der Stoff oder das Leder, ausgebeult, insbesondere periodisch. Die Massageeinrichtung ist gemäß einem Verfahren betrieben, bei dem mittels eines Bestandteils der Massageeinrichtung eine Änderung einer Kapazität aufgrund einer Änderung einer Belegung des Abschnitts des Sitzes erfasst wird, und bei dem anhand der Änderung der Kapazität eine Bestromung des Elektromotors angepasst wird.

Ein Bestandteil einer Massageeinrichtung eines Sitzes, die einen Massageantrieb mit einer mittels eines Elektromotors angetriebenen Unwucht und eine elektrische Leitung zum Betrieb des Massageantriebs aufweist, wird als kapazitive Sensorelektrode zur Erkennung einer Belegung zumindest eines Abschnitts des Sitzes verwendet. Der Sitz und somit die Massageeinrichtung sind bevorzugt ein Bestandteil eines Kraftfahrzeugs, und die elektrische Leitung ist geeigneterweise elektrisch mit dem Massageantrieb kontaktiert. Zusammenfassend erfüllt somit ein Bestandteil der Massageeinrichtung eine Doppelfunktion, nämlich einmal das Erkennen der Belegung des Abschnitts des Sitzes sowie eine weitere Funktion, die dem Ausführen einer Massagefunktion dient. Infolgedessen sind der Anteil an benötigten Bauteilen und somit Herstellungskosten reduziert.

Sofern ein Bauteil als erstes, zweites, drittes,... Bauteil bezeichnet wird, ist insbesondere lediglich darunter ein bestimmtes Bauteil zu verstehen. Insbesondere bedeutet dies nicht, dass eine bestimmte Anzahl an derartigen Bauteilen vorhanden ist. So impliziert insbesondere nicht, dass ein zweiter Massageantrieb vorhanden ist, sofern der dritte Massageantrieb vorhanden ist.

Die im Zusammenhang mit der Massageeinrichtung erläuterten Weiterbildungen und Vorteile sind sinngemäß auch auf den Fahrzeugsitz/die Verwendung zu übertragen und umgekehrt.

Nachfolgend werden Ausführungsbeispiele der Erfindung anhand einer Zeichnung näher erläutert. Darin zeigen:
- Fig. 1: schematisch vereinfacht ein Kraftfahrzeug mit einem eine Massageeinrichtung umfassenden Fahrzeugsitz,
- Fig. 2: perspektivisch die Massageeinrichtung mit mehreren Massageantrieben,
- Fig. 3: schematisch einen der Massageantriebe,
- Fig. 4: perspektivisch den Fahrzeugsitz mit der Massageeinrichtung,
- Fig. 5: ein Verfahren zum Betrieb der Massageeinrichtung, und
- Fig. 6, 7: unterschiedlich Funktionsweisen der Massageeinrichtung.

Einander entsprechende Teile sind in allen Figuren mit den gleichen Bezugszeichen versehen.

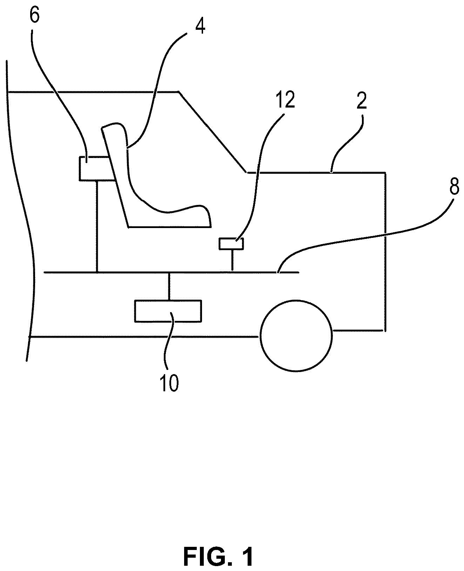

In Fig. 1 ist schematisch vereinfacht ein Kraftfahrzeug 2 mit einem Fahrzeugsitz 4 gezeigt. Der Fahrzeugsitz 4 umfasst eine Massageeinrichtung 6, die mit einem weiteren BUS-System 8 signaltechnisch verbunden ist. Das weitere BUS-System 8 basiert auf dem CAN-Standard, und ein Bordcomputer 10 sowie ein weiterer BUS-Teilnehmer 12 sind jeweils ein Bestandteil des weiteren BUS-Systems 8. Mittels des Bordcomputers 10 werden Anforderungen an die Massageeinrichtung 6 sowie den weiteren BUS-Teilnehmer 12 übertragen. Auch findet ein Austausch von Betriebsdaten über das weitere BUS-System 8 statt.

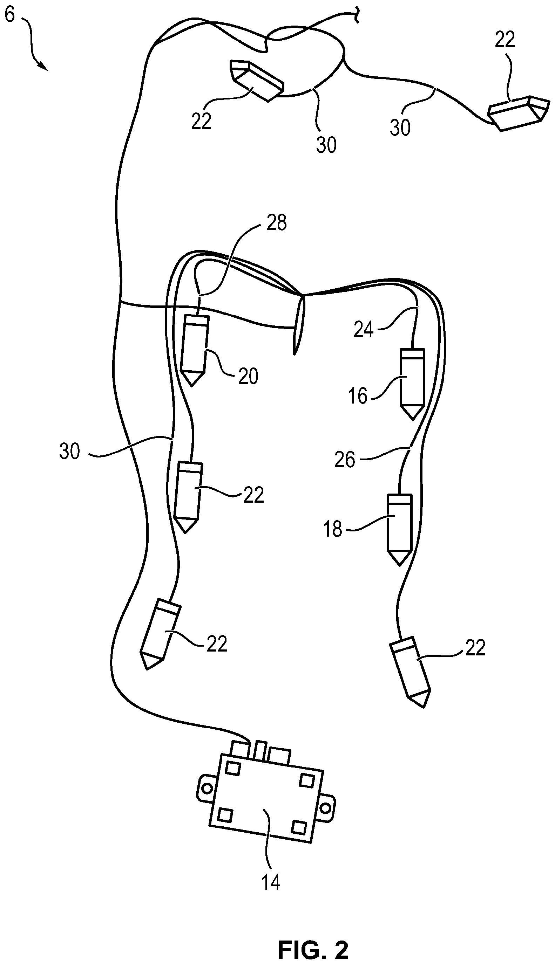

In Fig. 2 ist die Massageeinrichtung 6 dargestellt, die ein Steuergerät 14 sowie einen ersten Massageantrieb 16, einen zweiten Massageantrieb 18, einen dritten Massageantrieb 20 und fünf weitere Massageantriebe 22 aufweist. Der erste Massageantrieb 16 ist mittels einer ersten elektrischen Leitung 24 und der zweite Massageantrieb 18 mittels einer zweiten elektrischen Leitung 26 mit dem Steuergerät 14 elektrisch und signaltechnisch gekoppelt. Der dritte Massageantrieb 20 ist mittels einer dritten elektrischen Leitung und die weiteren Massageantriebe 22 jeweils mittels einer weiteren elektrischen Leitung 30 signaltechnisch und elektrisch mit der Steuereinheit 14 gekoppelt. Hierbei dienen die elektrischen Leitungen 24, 26, 28, 30 jeweils dem Betrieb des jeweils zugeordneten Massageantriebs 14, 18, 20, 22. Die Massageeinrichtung 6 besteht aus den Massageantrieben 16, 18, 20, 22, den elektrischen Leitungen 24, 26, 28, 30 sowie dem Steuergerät 14.

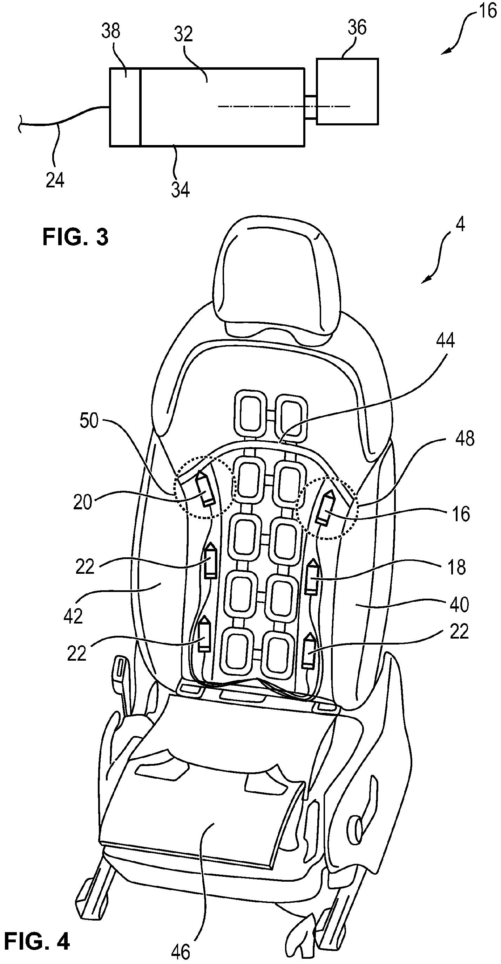

In Fig. 3 ist der erste Massageantrieb 16 dargestellt, der baugleich zu dem zweiten Massagenantrieb 18, dem dritten Massageantrieb 20 sowie den weiteren Massageantrieben 22 ist. Der erste Massageantrieb 16 weist einen Elektromotor 32 mit einem Gehäuse 34 aus einem metallischen Blech auf. An einer nicht näher dargestellten Welle des Elektromotors 32 ist eine Unwucht 36 angebunden, die somit mittels des Elektromotors 32 angetrieben ist. Bei einer Rotationsbewegung des Elektromotors 32 und somit einer Rotationsbewegung der Unwucht 36 wird der erste Massageantrieb 16 in eine rhythmische Bewegung versetzt. Ferner umfasst der erste Massageantrieb 16 eine Steuereinrichtung 38, mittels derer eine Bestromung des Elektromotors 32 erfolgt. Die Steuereinrichtung 38 ist elektrisch mit der ersten elektrischen Leitung 24 kontaktiert, und bei Betrieb werden zwischen dem Steuergerät 14 und der Steuereinrichtung 38 mittels der ersten elektrischen Leitung 24 Daten ausgetauscht, wobei mittels einer weiteren Ader der ersten elektrischen Leitung 24 ein elektrischer Stromfluss zu der Steuereinrichtung 38 bereitgestellt wird.

In Fig. 4 ist der Fahrersitz 4 perspektivisch jedoch ohne einen Sitzbezug dargestellt. Der (Fahrer-)Sitz 4 umfasst eine Rückenlehne 40, welche ein Formteil 42 aus einem Kaltschaum umfasst, in das eine der Stabilisierung dienende Haltestruktur 44 aus einem Metall eingebettet ist. Das Steuergerät 14 ist an der Unterseite einer Sitzfläche 46 des Sitzes 4 angebunden. Das Formteil 42 weist eine Anzahl an Ausnehmungen auf, wobei innerhalb jeweils einer von diesen der erste Massageantrieb 16, der zweite Massageantrieb 18, der dritte Massageantrieb 20 sowie die weiteren Massageantriebe 22 als auch die elektrischen Leitungen 24, 26, 28, 30 angeordnet sind. Die Massageantriebe 16, 18, 20, 22 sind zueinander beabstandet, und der erste Massageantrieb 16 ist einem Abschnitt 48 und der dritte Massageantrieb 20 einem zweiten Abschnitt 50 zugeordnet. Die Abschnitte 48, 50 korrespondieren hierbei zu den Bereichen des Sitzes 4, die bei Betrieb des jeweils zugeordneten Massageantriebs 16, 20 aufgrund der jeweiligen Unwucht 36 ausgebeult werden. Jedem der weiteren Massageantriebe 22 sowie dem zweiten Massageantrieb 18 ist ein nicht näher dargestellter Abschnitt des Sitzes 4 zugeordnet. Die jeweiligen dem Betrieb des zugeordneten Massageantriebs 16, 18, 20, 22 dienenden elektrischen Leitungen 24, 26, 28, 30 sind hierbei zumindest teilweise dem jeweiligen Abschnitt zugeordnet.

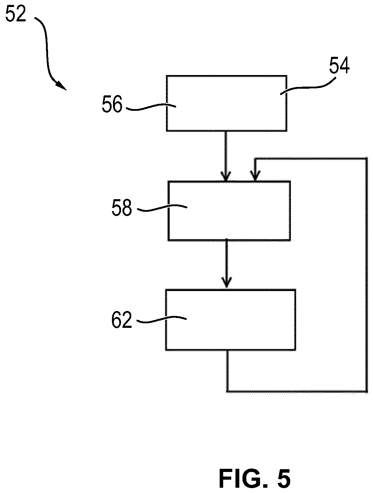

In Fig. 5 ist ein Verfahren 52 zum Betrieb der Massageeinrichtung 6 dargestellt, welches zumindest teilweise mittels des Steuergeräts 14 sowie der jeweiligen Steuereinrichtungen 38 der Massageantriebe 14, 18, 20, 22 ausgeführt wird. In einem ersten Arbeitsschritt 54 wird eine Benutzereingabe 56 erfasst, welche über das Bus-System 8 an das Steuergerät 14 geleitet wird. Die Benutzereingabe 56 korrespondiert zu einer Anforderung des Benutzers des Sitzes 4 eine Massagefunktion auszuführen.

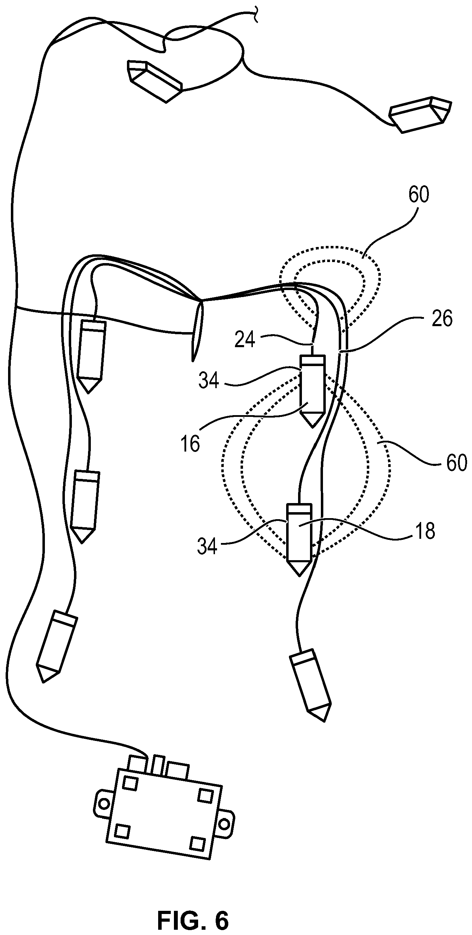

In einem zweiten Arbeitsschritt 58 wird eine Änderung einer Kapazität aufgrund einer Änderung einer Belegung zumindest des Abschnitts 48 des Sitzes 4 erfasst. Hierfür wird, in einer Ausführungsform, die in Fig. 6 dargestellt ist, mittels des Gehäuses 34 des Elektromotors 32 des ersten Massageantriebs 16 sowie mittels des Gehäuses 34 des zweiten Massageantriebs 18 ein elektromagnetisches Feld 60 erstellt. Die Parameter des elektromagnetischen/elektrischen Feldes 60 werden mit in dem Steuergerät 14 sowie den Steuereinrichtungen 38 hinterlegten Werten verglichen, die zu keiner Belegung korrespondieren, also wenn der Benutzer den Abschnitt 48 nicht belegt, und somit von diesem beabstandet ist. Mit anderen Worten bildet sich zwischen dem ersten Massageantrieb 16 und dem zweiten Massageantrieb 18 das elektromagnetische Feld 60 aus, und die Gehäuse 34 der beiden Massageantriebe 16, 18 wirken als Elektroden eines mittels der Gehäuse 34 gebildeten Kondensators. Hierfür werden die Gehäuse 34 auf ein bestimmtes elektrisches Potential gebracht, welches beispielsweise konstant oder zeitlich oszillierend ist. In Abhängigkeit der ermittelten, auftretenden Kapazität, die als Parameter des elektromagnetischen Feldes 60 fungiert, ist somit ein Rückschluss ermöglicht, ob sich das elektromagnetische Feld 60 lediglich im Wesentlichen in Luft oder in einem Bereich des Körpers des Benutzers des Sitzes 4 ausbreitet. Sofern die ermittelte Dielektrizitätskonstante zu dem Benutzer des Sitzes 4 korrespondiert und somit insbesondere von der Dielektrizitätskonstanten abweicht, die Luft aufweist, ist die Belegung erkannt.

In einer weiteren Ausgestaltung wird das elektrische Feld 60 zwischen der ersten Leitung 24 und der zweiten Leitung 26 erstellt. Somit wird mit den beiden elektrischen Leitungen 24, 26 der Kondensator bereitgestellt. Zusammenfassend wird mittels eines Bestandteils der Massageeinrichtung 6 die Änderung der Kapazität aufgrund einer Änderung einer Belegung des Abschnitts 48 des Sitzes 4 erfasst, wobei als Bestandteil entweder das Gehäuse 34 des Elektromotors 32 des ersten Massageantriebs 16 oder die erste elektrische Leitung 24 herangezogen wird. In einer Alternative wird das elektromagnetische Feld 60 zwischen einer der Leitungen 24, 26 eines der Massageantriebe 16, 18 und zwischen einer weiteren elektrischen Leitung 24, 26 erstellt wird. Zusammenfassend wird die Kapazität zwischen dem Gehäuse 34 des ersten Massageantriebs 16 oder der ersten elektrischen Leitung 24 und dem Gehäuse 34 des zweiten Massagenantriebs 18 und/oder der zweiten elektrischen Leitung 26 ermittelt.

In einem sich anschließenden dritten Arbeitsschritt 62 wird anhand der Änderung der Kapazität eine Bestromung des Elektromotors 32 des ersten Massageantriebs 16 angepasst. Hierbei wird die Bestromung vergrößert, falls im zweiten Arbeitsschritt 58 erfasst wurde, dass eine Belegung des Abschnitts 48 vorherrscht. Sofern keine Belegung des Abschnitts 48 erfasst wurde, also falls der Benutzer nicht an dem Abschnitt 48 anliegt, wird die Bestromung des Elektromotors 32 des ersten Massageantriebs 16 unterlassen oder der Elektromotor 32 wird in einem bestimmten Bereich betrieben, bei dem das Aussenden von akustischen Signalen reduziert ist. In einer weiteren Alternative der Erfindung wird direkt nach Erfassen der Benutzereingabe 56 die Bestromung des Elektromotors 32 gestartet, und im Anschluss hieran wird zunächst der zweite Arbeitsschritt 58 ausgeführt. In Abhängigkeit der dann erfassten Kapazität wird die Bestromung angepasst, die direkt im Anschluss an den ersten Arbeitsschritt 54 erstellt wird. Alternativ wird zunächst, bevor die Bestromung des Elektromotors 32 erfolgt, die Kapazität erfasst und erst dann, wenn die Belegung erkannt ist, der Elektromotor 32 in eine Rotationsbewegung versetzt.

Ferner wird mittels des dritten Massageantriebs 20 und/oder der dritten elektrischen Leitung 28 erfasst, ob der zweite Abschnitt 50 belegt ist. Sofern der zweite Abschnitt 50 belegt ist, wird auch dieser Massageantrieb 20 bestromt und somit die Unwucht 36 des dritten Massageantriebs 20 in eine Bewegung versetzt. Sofern der zweite Abschnitt 50 nicht belegt ist, unterbleibt die Bestromung des Elektromotors 32 bzw. der Elektromotor 32 wird in einem vorher definierten Drehzahlbereich betrieben. Auch mittels des zweiten Massageantriebs 18 und der weiteren Massageantriebe 22 wird die Belegung des jeweils zugeordneten Abschnitts erfasst und in Abhängigkeit hiervon der jeweilige Elektromotor 32 bestromt.

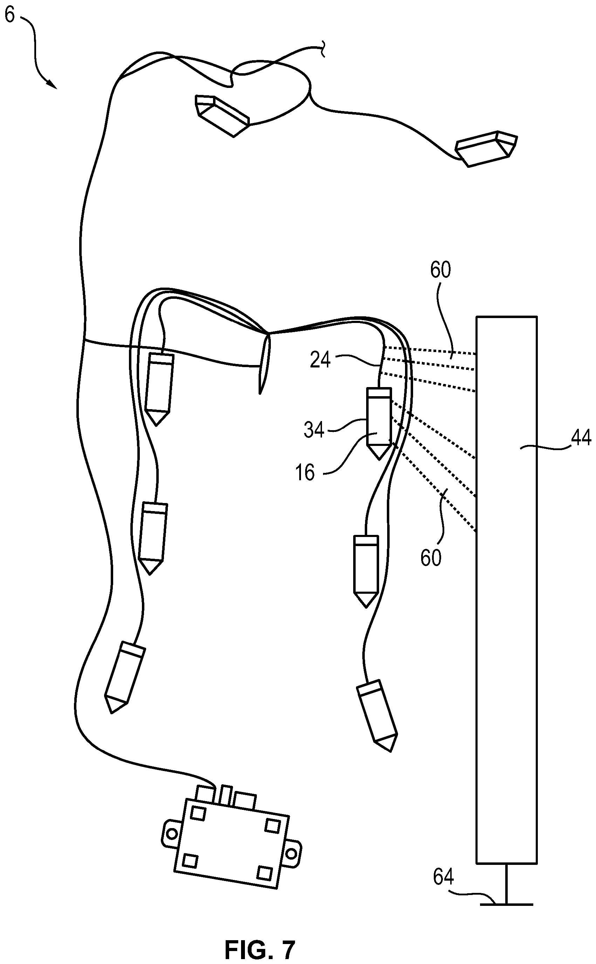

In Fig. 7 ist eine Abwandlung der Massageeinrichtung 6 dargestellt. Hierbei wird das elektromagnetische Feld 60 zwischen dem Gehäuse 34 des ersten Massageantriebs 16 bzw. der ersten elektrischen Leitung 24 und der Haltestruktur 44 erstellt, welche elektrisch mit Masse 64 kontaktiert ist. Masse 64 ist hierbei mittels der Karosserie des Kraftfahrzeugs 2 bereitgestellt und die Haltestruktur 4 ist elektrisch mit der Karosserie kontaktiert. Somit wird die Kapazität zwischen dem ersten Massageantrieb 16 bzw. der ersten elektrischen Leitung 24 und Masse 64 ermittelt. Auch wird jeweils ein elektrisches Feld 60 zwischen Masse 64 und dem zweiten Massageantrieb 18, dem dritten Massageantrieb 20, den weiteren Massageantrieben 22 bzw. der zweiten elektrischen Leitung 26, der dritten elektrischen Leitung 28 oder den weiteren elektrischen Leitungen 30 und Masse 64 erstellt, wobei dies beispielsweise sukzessive erfolgt. Die Auswertung der Kapazität erfolgt zweckmäßigerweise mittels der Steuereinrichtung 38 des jeweiligen Massageantriebs 16, 18, 20, 22.

Zusammenfassend werden die Elektromotoren 32 oder die elektrischen Leitungen 24, 26, 28, 30 sowie optional die Haltestruktur 44 als kapazitive Sensorelektroden zur Sitzbelegungserkennung herangezogen. Dies erfolgt beispielsweise qualitativ oder quantitativ. Sofern erkannt ist, dass der jeweilige Abschnitt 48, 50 nicht belegt ist, also falls die Person den Rücken nicht der Rückenlehne 40 hat, wird die Vibration in diesem Abschnitt 48, 50 eingestellt, was zu einem Schutz der Elektromotoren 32 führt. Das Messprinzip ist hierbei entweder ein ein- oder zwei-Elektroden-Prinzip. In nochmals anderen Worten weist jeder der Massageantriebe 16, 18, 20, 22 ein metallisches Gehäuse 34 auf, welches in dem Kaltschaum des Formteils 42 verbaut ist. Diese Gehäuse 34 werden als Elektroden verwendet, um das elektromagnetische Feld 60 aufzubauen, welches insbesondere ein kapazitives Feld ist. Das elektromagnetische Feld 60 wird hierbei mittels der Steuereinrichtung 38 ausgewertet, und das elektromagnetische Feld wird zwischen zwei oder mehreren Bestandteilen 16, 18, 20, 22, 24, 26, 28, 30 der Massageeinrichtung 6 oder zwischen den Bestandteilen 16, 18, 20, 22, 24, 26, 28, 30 der Massageeinrichtung 6 und Masse 64 aufgebaut. Zusammenfassend wird entweder das elektromagnetische Feld 60 zwischen lediglich Bestandteilen 16, 18, 20, 22, 24, 26, 28, 30 der Massageeinrichtung 6 oder zwischen den Bestandteilen 16, 18, 20, 22, 24, 26, 28, 30 der Massageeinrichtung 6 und Masse 64 erstellt.

Aufgrund des Verfahrens 52 kann erkannt werden, ob für den Benutzer der Betrieb jedes der Massageantriebe 16, 18, 20, 22 wahrnehmbar ist, und ob somit dieser aktuell benutzt wird. Nicht verwendete Massageantriebe 16, 18, 20, 22, also diejenigen Massageantriebe, deren zugeordneter Abschnitt nicht belegt ist, werden entweder abgeschaltet oder in einem akustisch vorteilhaften Arbeitspunkt betrieben. Zudem kann aufgrund der Massageantriebe 16, 18, 20, 22 sowie der elektrischen Leitungen 24, 26, 28, 30 eine detaillierte Sitzbelegungserkennung realisiert werden, und zusätzliche Bauteile zur Erkennung der Sitzbelegung sind nicht erforderlich. Sofern das elektromagnetische Feld 60 lediglich zwischen den Bestandteilen 16, 18, 20, 22, 24, 26, 28, 30 der Massageeinrichtung 6 erstellt wird, ist eine spezielle Anpassung auf weitere Bestandteile des Sitzes 4 nicht erforderlich, so dass die Montage sowie Konzeptionierung der Massageeinrichtung 6 vereinfacht ist, und eine vergleichsweise große Unabhängigkeit von der Sitzstruktur und insbesondere der Haltestruktur 44 gegeben ist. Sofern das elektromagnetische Feld 60 zwischen jeweils einem Bestandteil 16, 18, 20, 22, 24, 26, 28, 30 der Massageeinrichtung 6 und Masse 64 erstellt wird, kann jedes der Bestandteile 16, 18, 20, 22, 24, 26, 28, 30 einzeln vermessen werden, was zu einer vergleichsweise detaillierten Sitzbelegungserkennung führt.

Die Erfindung ist nicht auf die vorstehend beschriebenen Ausführungsbeispiele beschränkt. Vielmehr können auch andere Varianten der Erfindung von dem Fachmann hieraus abgeleitet werden, ohne den Gegenstand der Erfindung zu verlassen, der in den Ansprüchen definiert ist. Insbesondere sind ferner alle im Zusammenhang mit den einzelnen Ausführungsbeispielen beschriebene Einzelmerkmale auch auf andere Weise miteinander kombinierbar, ohne den Gegenstand der Erfindung zu verlassen, der in den Ansprüchen definiert ist.

### Bezugszeichenliste

- 2: Kraftfahrzeug
- 4: Fahrzeugsitz
- 6: Massageeinrichtung
- 8: BUS-System
- 10: Bordcomputer
- 12: weiterer BUS-Teilnehmer
- 14: Steuergerät
- 16: erster Massageantrieb
- 18: zweiter Massageantrieb
- 20: dritter Massageantrieb
- 22: weiterer Massageantrieb
- 24: erste elektrische Leitung
- 26: zweite elektrische Leitung
- 28: dritte elektrische Leitung
- 30: weitere elektrische Leitung
- 32: Elektromotor
- 34: Gehäuse
- 36: Unwucht
- 38: Steuereinrichtung
- 40: Rückenlehne
- 42: Formteil
- 44: Haltestruktur
- 46: Sitzfläche
- 48: Abschnitt
- 50: zweiter Abschnitt
- 52: Verfahren
- 54: erster Arbeitsschritt
- 56: Benutzereingabe
- 58: zweiter Arbeitsschritt
- 60: elektromagnetisches Feld
- 62: dritter Arbeitsschritt
- 64: Masse

## Patentansprüche

1. Verfahren (52) zum Betrieb einer Massageeinrichtung (6) eines Sitzes (4), insbesondere eines Kraftfahrzeugs (2), die einen Massageantrieb (16) mit einer mittels eines Elektromotors (32) angetriebenen Unwucht (36) und eine elektrische Leitung (24) zum Betrieb des Massagenantriebs (16) aufweist, bei dem
- mittels eines Bestandteiles (16, 24) der Massageeinrichtung (6) eine Änderung einer Kapazität aufgrund einer Änderung einer Belegung zumindest eines Abschnitts (48) des Sitzes (4) erfasst wird,
- anhand der Änderung der Kapazität eine Bestromung des Elektromotors (32) angepasst wird,
- wobei als Bestandteil ein Gehäuse (34) des Massageantriebs (16) oder die elektrische Leitung (24) herangezogen wird,
- oder wobei die Kapazität zwischen dem Bestandteil (16, 24) und einem zweiten Massageantrieb (18) und/oder einer zweiten elektrischen Leitung (26) ermittelt wird.

2. Verfahren (52) nach Anspruch 1,
**dadurch gekennzeichnet,**
**dass** die Kapazität im Anschluss an eine Benutzereingabe (56) erfasst wird.

3. Verfahren (52) nach Anspruch 1 oder 2,
**dadurch gekennzeichnet,**
**dass** eine Bestromung vergrößert wird, falls die erfasste Kapazität zu einer Belegung des Abschnitts (48) des Sitzes (4) korrespondiert.

4. Verfahren (52) nach einem der vorhergehenden Ansprüche,
**dadurch gekennzeichnet,**
**dass** die Kapazität zwischen dem Bestandteil (16, 24) und Masse (64) ermittelt wird.

5. Verfahren (52) nach einem der vorhergehenden Ansprüche,
**dadurch gekennzeichnet,**
**dass** als Bestandteil ein Gehäuse des Elektromotors (32) herangezogen wird.

6. Massageeinrichtung (6) eines Sitzes (4), insbesondere eines Kraftfahrzeugs (2), mit einem Massagenantrieb (16), der eine mittels eines Elektromotors (32) angetriebene Unwucht (36) aufweist, und mit einer elektrischen Leitung (24) zum Betrieb des Massagenantriebs (16), wobei der Massagenantrieb (16) und/oder die elektrische Leitung (24) einem Abschnitt (48) zugeordnet sind, und die gemäß einem Verfahren (52) nach einem der Ansprüche 1 bis 5 betrieben ist.

7. Massageeinrichtung (6) nach Anspruch 6,
**gekennzeichnet durch**
einen dritten Massageantrieb (20) und/oder eine dritte elektrische Leitung (28), die einem zweiten Abschnitt (50) zugeordnet sind.

8. Fahrzeugsitz (4) eines Kraftfahrzeugs (2), insbesondere Fahrersitz, mit einer Massageeinrichtung (6) nach einem der Ansprüche 6 oder 7.

9. Verwendung eines Bestandteiles (16, 24) einer Massageeinrichtung (6) eines Sitzes (4), insbesondere eines Kraftfahrzeugs (2), die einen Massagenantrieb (16) mit einer mittels eines Elektromotors (32) angetriebene Unwucht (36) und eine elektrische Leitung (24) zum Betrieb des Massagenantriebs (16) aufweist, als kapazitive Sensorelektrode zur Erkennung einer Belegung zumindest eines Abschnitts (48) des Sitzes (4), wobei als Bestandteil ein Gehäuse (34) des Massageantriebs (16) oder die elektrische Leitung (24) herangezogen wird, oder wobei die Kapazität zwischen dem Bestandteil (16, 24) und einem zweiten Massageantrieb (18) und/oder einer zweiten elektrischen Leitung (26) ermittelt wird.

## Claims

1. Method (52) for operating a massage device (6) of a seat (4), in particular of a motor vehicle (2), comprising a massage drive (16) with an unbalance (36) driven by means of an electric motor (32) and an eletrical line (24) for operating the massage drive (16), in which
- by means of a component (16, 24) of the massage device (6), a change in capacitance due to a change in occupancy of at least a section (48) of the seat (4) is detected,
- an energization of the electric motor (32) is adjusted based on the change in capacitance,
- wherein as a component a housing (34) of the massage drive (16) or the electrical line (24) is used,
- or wherein the capacitance between the component (16, 24) and a second massage drive (18) and/or a second electrical line (26) is determined.

2. Method (52) according to claim 1,
**characterized in**
**that** the capacitance is detected following a user input (56).

3. Method (52) according to claim 1 or 2,
**characterized in**
**that** an energization is increased if the detected capacitance corresponds to an occupancy of the section (48) of the seat (4).

4. Method (52) according to one of the preceding claims,
**characterized in**
**that** the capacitance between the component (16, 24) and ground (64) is determined.

5. Method (52) according to one of the preceding claims,
**characterized in**
**that** as a component a housing (34) of the electric motor (32) is used.

6. Massage device (6) of a seat (4), in particular of a motor vehicle (2), with a massage drive (16) comprising an imbalance (36) driven by means of an electric motor (32), and with an eletrical line (24) for operating the massage drive (16), wherein the massage drive (16) and/or the eletrical line (24) are assigned to a section (48), and which is operated according to a method (52) according to one of claims 1 to 5.

7. Massage device (6) according to claim 6,
**characterized in**
a third massage drive (20) and/or a third electrical line (28) associated with a second section (50).

8. Vehicle seat (4) of a motor vehicle (2), in particular driver's seat, with a massage device (6) according to one of claims 6 or 7.

9. Use of a component (16, 24) of a massage device (6) of a seat (4), in particular of a motor vehicle (2), comprising a massage drive (16) with an imbalance (36) driven by means of an electric motor (32) and an electrical line (24) for operating the massage drive (16), as a capacitive sensor electrode for detecting an occupancy of at least one section (48) of the seat (4), wherein a housing (34) of the massage drive (16) or the electrical line (24) is used as a component, or wherein the capacitance between the component (16, 24) and a second massage drive (18) and/or a second electrical line (26) is determined.

## Revendications

1. Procédé (52) pour faire fonctionner un dispositif de massage (6) d'un siège (4), en particulier d'un véhicule automobile (2), comprenant un entraînement de massage (16) avec un déséquilibre (36) entraîné au moyen d'un moteur électrique (32) et une ligne électrique (24) pour faire fonctionner l'entraînement de massage (16), dans lequel
- au moyen d'un composant (16, 24) du dispositif de massage (6), une modification d'une capacité due à une modification d'une occupation d'au moins une section (48) du siège (4) est détectée,
- l'alimentation en courant du moteur électrique (32) est ajustée en fonction de la modification de la capacité,
- dans lequel un boîtier (34) de l'entraînement de massage (16) ou la ligne électrique (24) est utilisé comme composant,
- ou dans lequel la capacité entre le composant (16, 24) et un deuxième entraînement de massage (18) et/ou une deuxième ligne électrique (26) est déterminée.

2. Procédé (52) selon la revendication 1,
**caractérisé en ce**
**que** la capacité est détectée suite à une entrée de l'utilisateur (56).

3. Procédé (52) selon la revendication 1 ou 2,
**caractérisé en ce**
**qu'**une alimentation en courant est augmentée si la capacité détectée correspond à une occupation de la section (48) du siège (4).

4. Procédé (52) selon l'une des revendications précédentes,
**caractérisé en ce**
**que** la capacité entre le composant (16, 24) et la masse (64) est déterminée.

5. Procédé (52) selon l'une des revendications précédentes,
**caractérisé en ce**
**qu'**un boîtier (34) du moteur électrique (32) est utilisé comme composant.

6. Dispositif de massage (6) d'un siège (4), en particulier d'un véhicule automobile (2), avec un entraînement de massage (16) comprenant un déséquilibre (36) entraîné au moyen d'un moteur électrique (32), et avec une ligne électrique (24) pour l'actionnement de l'entraînement de massage (16), l'entraînement de massage (16) et/ou la ligne électrique (24) étant associés à une section (48), et qui est actionné selon un procédé (52) selon l'une des revendications 1 à 5.

7. Dispositif de massage (6) selon la revendication 6,
caractérisé en
un troisième entraînement de massage (20) et/ou une troisième ligne électrique (28) associées à une deuxième section (50).

8. Siège de véhicule (4) d'un véhicule automobile (2), en particulier siège de conducteur, avec un dispositif de massage (6) selon l'une des revendications 6 ou 7.

9. Utilisation d'un composant (16, 24) d'un dispositif de massage (6) d'un siège (4), en particulier d'un véhicule automobile (2), comprenant un entraînement de massage (16) avec un déséquilibre (36) entraîné au moyen d'un moteur électrique (32) et une ligne électrique (24) pour le fonctionnement de l'entraînement de massage (16), comme électrode de capteur capacitif pour la détection d'une occupation d'au moins une section (48) du siège (4), un boîtier (34) de l'entraînement de massage (16) ou de la ligne électrique (24) étant utilisé comme composant, ou la capacité entre le composant (16, 24) et un deuxième entraînement de massage (18) et/ou une deuxième ligne électrique (26) étant déterminée.
